(19) Europäisches Patentamt
European Patent Office
Office européen des brevets

(11) EP 3 093 310 A1

(12) EUROPEAN PATENT APPLICATION

(43) Date of publication:
16.11.2016 Bulletin 2016/46

(51) Int Cl.:
*C08J 7/04* (2006.01) *C09D 4/06* (2006.01)

(21) Application number: 16169318.9

(22) Date of filing: 12.05.2016

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(30) Priority: 13.05.2015 JP 2015098093

(71) Applicant: Shin-Etsu Chemical Co., Ltd.
Tokyo (JP)

(72) Inventors:
- Kohei, MASUDA
Annaka-shi, Gunma (JP)
- Kazuhiro, TSUCHIDA
Annaka-shi, Gunma (JP)
- Yukimasa, AOKI
Annaka-shi, Gunma (JP)

(74) Representative: Stoner, Gerard Patrick
Mewburn Ellis LLP
City Tower
40 Basinghall Street
London EC2V 5DE (GB)

# (54) COATED ARTICLE MANUFACTURING METHOD, COATING COMPOSITION AND LAMINATE

(57) A method of manufacturing a coated article includes the steps of (A) applying a radiation-curable coating which contains a specific siloxane acrylate to an organic resin substrate so as to obtain an uncured film-covered article, and (B) irradiating the uncured film-covered article with radiation to cure the film. The leveling ability of the coating can be improved without diluting the coating more than necessary and without adding more leveling agent than needed.

EP 3 093 310 A1

## Description

### TECHNICAL FIELD

This invention relates to a method of manufacturing a coated article, a coating used in such a method, and a laminate containing a film obtained from the coating. More specifically, the invention relates to a coated article manufacturing method and leveling ability improving method in which, by using a specific siloxane acrylate in a radiation-curable coating, effects such as Bénard convection are suppressed even when the amount of leveling agent included is reduced, enabling a good film appearance to be obtained; to a radiation-curable coating for use in such a method; and to a laminate having an inorganic vapor-deposited layer formed by a dry film forming process on a coated article obtained by applying and curing such a coating on an organic resin substrate, which laminate exhibits an excellent adhesion owing to the reduced amount of leveling agent and the properties of the siloxane acrylate.

### BACKGROUND

Bénard convection is a phenomenon that arises when heat flow exists in a fluid in layer form. Under certain conditions, random microscopic molecular movement suddenly becomes orderly on a macroscopic level, appearing as convection. Even in coating applications, this is known to be a factor that influences the appearance of the resulting film. Coatings often consist of resin ingredients that have been thinned with solvents. Following the application of a coating, heat transfer arises in the solvent evaporation step, sometimes causing Bénard convection. When the coating cures in a state where Bénard convection has arisen, the resulting film may have a streaked or wavy appearance, which is undesirable. If this happens, the coating is said to have a poor leveling ability. A variety of measures could be taken to address this problem.

The most common way to improve leveling is to add a type of surfactant called a leveling agent. Various types of leveling agents are known, including silicone-based agents (such as those described in JP 5234065), polyether-based agents (such as those described in JP-A 2011-26594), and fluoropolymer-based agents (such as those described in JP 5204634). Suitable use can be made of a leveling agent having a good compatibility with the coating.

Thinning the resin ingredients of the coating is often used as another way to improve leveling (see, for example, paragraph [0032] of JP-A 2009-179678).

### Citation List

Patent Document 1: JP 5234065
Patent Document 2: JP-A 2011-26594
Patent Document 3: JP 5204634
Patent Document 4: JP-A 2009-179678

### THE INVENTION

It is therefore an object of this invention to provide a method of manufacturing a coated article using a coating which has an excellent leveling ability and wherein Bénard convection is suppressed even when the amount of leveling agent included is reduced, thereby enabling a good film appearance to be obtained. Further aspects of the invention are a coating composition for use in such a method, a coated product thereof, and a laminate containing a film obtained from the coating.

It has become apparent from investigations by the inventors that there are certain cases where merely adding a leveling agent and/or diluting the coating as a way to improve the leveling ability of a coating will not result in satisfactory properties. Especially, these include cases in which a weather-resistant laminate is manufactured by the successive lamination of (i) a layer formed by applying and curing a radiation-curable coating on a resin substrate, and (ii) an inorganic vapor-deposited layer. For the use of a weather-resistant laminate in, for example, automotive laminated glass windows to be conceivable, the laminate must give excellent visibility. Hence, it is preferable for the coating furnished for the production of such a laminate to have a good leveling ability even when applied onto a large resin substrate. However, adding a leveling agent often interferes with adhesion between layer (i) and layer (ii), and so adding a large amount is undesirable. Diluting the coating does help to increase the leveling ability, but it makes layer (i) too thin. In applications where weather resistance is desired, it is preferable for layer (i) to have a certain degree of thickness. Therefore, in arriving at this invention, a new problem that arose was how to improve the leveling ability of a radiation-curable coating without diluting the coating more than is necessary and also without adding more leveling agent than

needed.

This problem can be expressed in terms of a formula. Bénard convection is known to be governed by a dimensionless number called the Rayleigh number (Ra) shown in formula (1).

$$Ra = g\beta(T_s - T_\infty)x^3/(\nu\alpha) \qquad \text{Formula (1)}$$

Here, g represents gravitational acceleration, β is the volume expansion coefficient, $T_s$ is the object surface temperature, $T\infty$ is the fluid temperature, x is the characteristic length, v is the coefficient of kinematic viscosity, and α is the thermal diffusivity. Bénard convection is thought to arise when the Rayleigh number (Ra) is in a specific range (defined by a lower limit critical value and an upper limit critical value). At or below the lower limit critical value, a smooth interface forms due to laminar flow. At or above the upper limit critical value, a homogeneous (smooth) interface forms due to completely turbulent flow. The approach of diluting the resin ingredients in the coating has the effect in formula (1) of making v smaller, and thus serves to set Ra at or above the upper limit critical value, forming a homogeneous interface. On the other hand, adding a leveling agent lowers the surface tension of the coating, and thus serves to maintain a smooth interface regardless of the generation of convection. Although it is apparent from formula (1) that control of substrate temperature by preheating ($T_s$), coating application environments (β, α) and a film thickness (x) are also physically effective, achieving all such physical factors in the actual application environments has been sluggish. The inventors have made a novel discovery that, by means of a chemical factor other than a leveling agent, a relatively thick cured film can be formed while also achieving film smoothness, and that where applicable, moreover, adhesion between the cured film layer (i) and a subsequently provided inorganic vapor-deposited layer (ii) can also be ensured.

The coefficient of kinematic viscosity v in formula (1) is a function of various factors, including the consistency of the coating, the type of solvent and the temperature. Of these, v is also strongly dependent on the resin ingredients making up the coating, although the polyfunctional (meth)acrylates that primarily make up radiation-curable coatings are known to be, in general, highly viscous substances. The viscosity of polyfunctional (meth)acrylate ingredients is an important factor in that it changes the coefficient of kinematic viscosity v of the coating, but it has not been fully investigated. In addition, polyfunctional acrylates having polyether linkages, which are relatively low viscosity compounds in spite of being polyfunctional (meth)acrylates, are known (JP-A 2013-82941), but studies by the inventors have shown that these do not lead to a solution of the current problem.

Based on their extensive investigations, the inventors have discovered that the use of a radiation-curable coating containing a siloxane acrylate of general formula (I) below is effective for resolving the above problems.

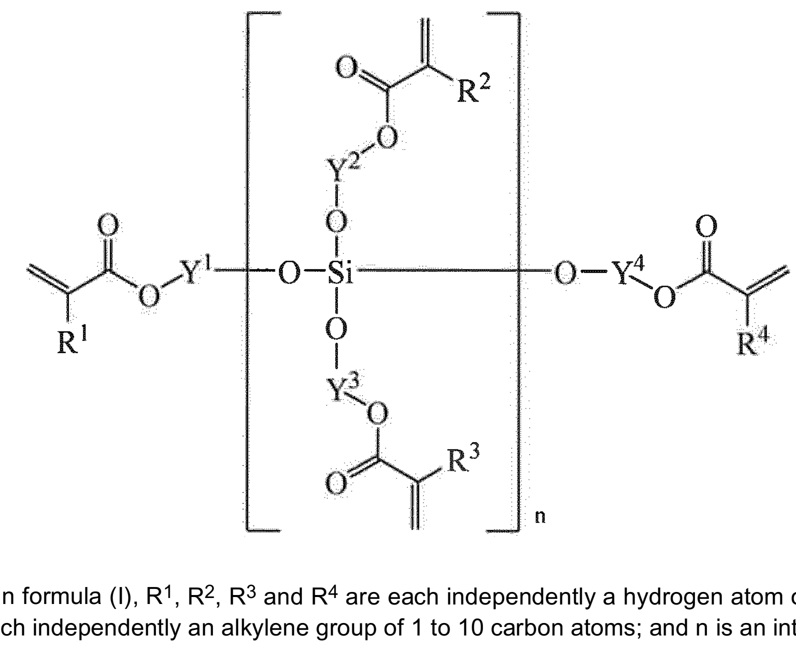

(I)

In formula (I), $R^1$, $R^2$, $R^3$ and $R^4$ are each independently a hydrogen atom or a methyl group; $Y^1$, $Y^2$, $Y^3$ and $Y^4$ are each independently an alkylene group of 1 to 10 carbon atoms; and n is an integer of at least 1 and up to 10.

Accordingly, in one aspect, the invention provides a method of manufacturing a coated article, which method includes the steps of: (A) applying a radiation-curable coating to an organic resin substrate so as to obtain an uncured film-covered article, and (B) irradiating the uncured film-covered article with radiation to cure the film. The radiation-curable coating contains a siloxane acrylate of general formula (I) below

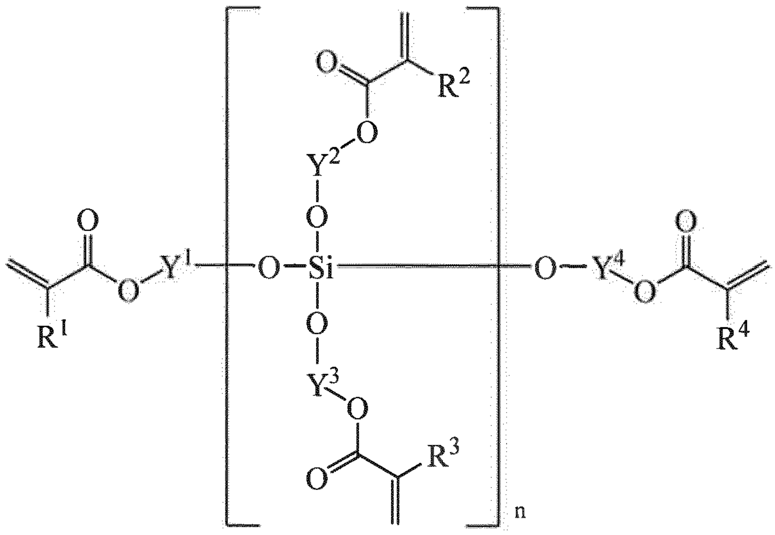

(I)

wherein $R^1$, $R^2$, $R^3$ and $R^4$ are each independently a hydrogen atom or a methyl group; $Y^1$, $Y^2$, $Y^3$ and $Y^4$ are each independently an alkylene group of 1 to 10 carbon atoms; and n is an integer of at least 1 and up to 10. The radiation-curable coating used in this method preferably has a content of leveling agent which is 0 to 3,000 ppm, based on the involatile solids of the coating. The coated article is an aspect of the proposals.

In a second aspect, the invention provides a radiation-curable coating which includes a siloxane acrylate of general formula (I) below

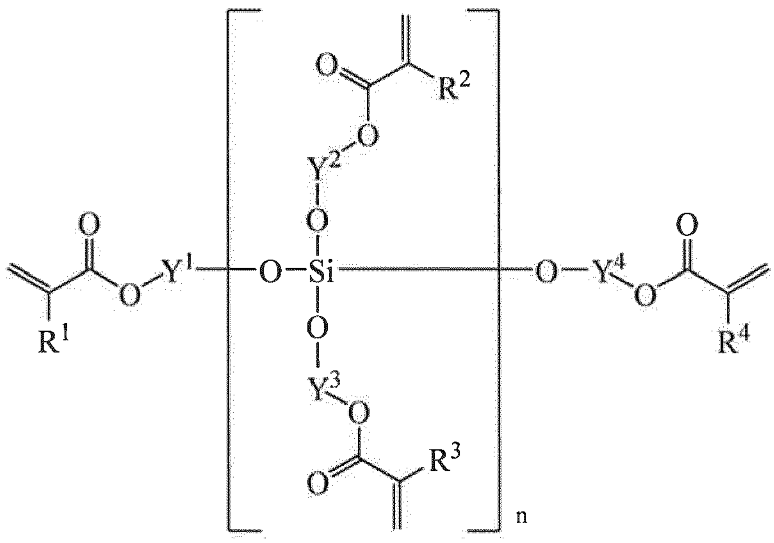

(I)

wherein $R^1$, $R^2$, $R^3$ and $R^4$ are each independently a hydrogen atom or a methyl group; $Y^1$, $Y^2$, $Y^3$ and $Y^4$ are each independently an alkylene group of 1 to 10 carbon atoms; and n is an integer of at least 1 and up to 10. In a preferred embodiment of this aspect of the invention, the radiation-curable coating further includes ($\alpha$) a polyfunctional (meth)acrylate, and may still further include one or more selected from the group consisting of ($\beta$) acrylic polymers, ($\gamma$) inorganic oxide fine particles and ($\delta$) light stabilizers. Preferably, in the radiation-curable coating, the proportion of siloxane acrylate of general formula (I), based on the coating solids exclusive of siloxane acrylate, is 5 to 100 wt %, and the proportions of the polyfunctional (meth)acrylate ($\alpha$), the acrylic polymer ($\beta$), the inorganic oxide fine particles ($\gamma$) and light stabilizer ($\delta$) in the base coating exclusive of component (I) are that the amount of component ($\alpha$) is 30 to 89.9 parts, the amount of component ($\beta$) is 5 to 30 parts, the amount of component ($\gamma$) is 5 to 30 parts and the amount of components ($\delta$) is 0.1 to 10 parts by weight in 100 parts by weight of the base coating solids.

In a third aspect, the invention provides a laminate having, arranged as successive layers: an organic resin substrate, (i) a layer formed by applying and curing the radiation-curable coating according to the second aspect of the invention on at least one side of the substrate, and desirably also (ii) an inorganic vapor-deposited layer. Here, layer (i)

preferably has a thickness of at least 5 μm and not more than 20 μm. Layer (ii) is desirably formed by a dry film-forming process.

ADVANTAGEOUS EFFECTS

We find that the radiation-curable coating compositions used in the manufacturing methods disclosed herein enable leveling ability to be improved without diluting the coating more than necessary and without adding more leveling agent than needed. Articles obtained by applying and curing the radiation-curable coating of the invention on an organic resin substrate ensure a film thickness sufficient to impart weather resistance and, moreover, manifest excellent adhesion when an inorganic vapor-deposited layer is additionally formed on the article. Laminates embodying the invention are found to have excellent weather resistance and abrasion resistance.

FURTHER EXPLANATIONS; OPTIONS AND PREFERENCES

The present proposed method for producing a coated article and for improving leveling ability, the coating used in this method and the laminate obtained using this method are described in detail below.

Improvement of Leveling Ability

The inventive method for improving the leveling ability is characterized by, in a coated article manufacturing method that includes the steps of (A) applying a radiation-curable coating to an organic resin substrate so as to obtain an uncured film-covered article, and (B) irradiating the uncured film-covered article with radiation to cure the film, the uniform and smooth leveling out of the uncured film on the substrate. The leveling ability improving effect is typically judged by examining the appearance after curing of the uncured film in step (B). The appearance is preferably free of visible defects such as streaks and waviness. In the inventive method, the absence of visible defects such as streaks and waviness even with the use of a reduced amount of leveling agent is more preferred. The appearance can be judged visually with the unaided eye, by microscope or in some other way.

Siloxane Acrylate

The inventive method for improving the leveling ability is characterized by including, within a radiation-curable coating, a siloxane acrylate of general formula (I) below.

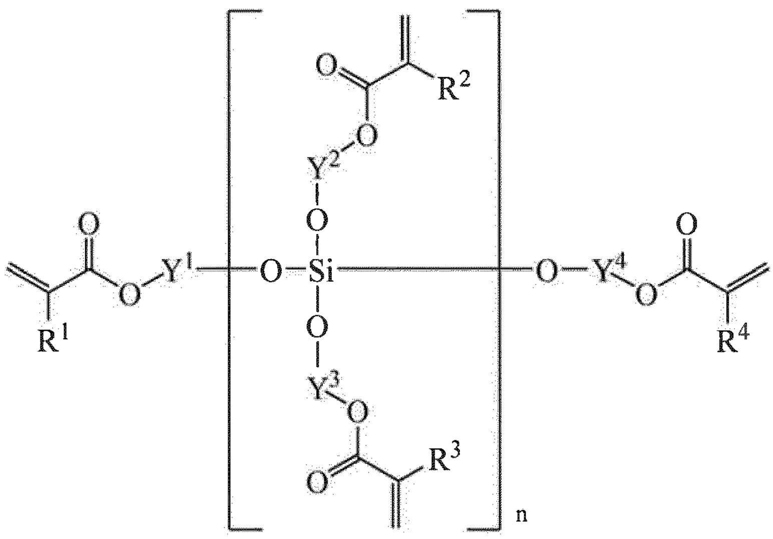

(I)

Here, $R^1$, $R^2$, $R^3$ and $R^4$ are each independently a hydrogen atom or a methyl group; $Y^1$, $Y^2$, $Y^3$ and $Y^4$ are each independently an alkylene group of 1 to 10 carbon atoms; and n is an integer of at least 1 and up to 10.

In general formula (I), $R^1$, $R^2$, $R^3$ and $R^4$ are each independently a hydrogen atom or a methyl group, and are preferably a hydrogen atom. $Y^1$, $Y^2$, $Y^3$ and $Y^4$ are each independently an alkylene group of 1 to 10 carbon atoms that may be branched, preferred examples of which include methylene, ethylene, propylene, butylene, pentylene, hexylene, heptylene, octylene, ethylhexylene, nonylene and decylene. Ethylene, butylene, hexylene and octylene are more preferred, and ethylene is even more preferred. The letter "n" is an integer of at least 1 and up to 10, preferably at least 1 and up to 8, and more preferably at least 2 and up to 5.

The siloxane acrylate of general formula (I) can be prepared by preferably reacting a silicate with an ω-functional alkylene alcohol bearing a (meth)acrylate group. Examples of preferred silicates include tetraalkoxysilanes such as tetramethoxysilane and tetraethoxysilane; and silicate oligomers such as Methyl Silicate 51, Methyl Silicate 53A, Ethyl Silicate 40 and Ethyl Silicate 48 (all available from Colcoat Co., Ltd.), and X-40-2308 (available from Shin-Etsu Chemical Co., Ltd.). Preferred ω-functional alkylene alcohols bearing a (meth)acrylate group include hydroxymethyl acrylate, hydroxyethyl acrylate, hydroxypropyl acrylate, hydroxybutyl acrylate and hydroxyoctyl acrylate.

Step (A): Obtaining an Uncured Film-Covered Article

In Step (A), an uncured film-covered article is obtained by applying a radiation-curable coating to an organic resin substrate. The radiation-curable coating composition is characterized by including a siloxane acrylate of general formula (I).

The organic resin substrate is preferably made of one or more organic resins selected from among, for example, polycarbonate, polyethylene terephthalate, polyester, polyamide, melamine and polyoxymethylene.

The method of applying the radiation-curable coating is preferably one or more selected from among, for example, flow coating, spray coating, bar coating, comma coating, dip coating and calender coating.

In step (A), following application of the coating, it is preferable to provide a time during which leveling is achieved by a mechanical operation such as standing. Characteristically, the leveling does not rely only on the action of a leveling agent; the low viscosity and low surface energy of the siloxane acrylate of general formula (I) also play a role in leveling. [It will be understood that herein the siloxane acrylate is regarded as distinct from "leveling agent".]

In the practice of the invention, the amount of leveling agent included in the radiation-curable coating is preferably 3,000 ppm or less, more preferably 2,500 ppm or less, and even more preferably 2,000 ppm or less, based on the coating resin solids. Including more than 3,000 ppm is undesirable both because it may impede adhesion between layer (i) and layer (ii) in a laminate obtained by arranging as successive layers (i) a layer formed by applying and curing the coating on a substrate, and (ii) an inorganic vapor-deposited layer, and because it may restrict the layer (ii) forming conditions.

The leveling agent is exemplified by the above-mentioned silicone-based, polyether-based and fluorocarbon-based leveling agents. Specific examples include polyether-modified silicone oils, polyether-modified polyolefins, ammonium, phosphonium and other onium-modified silicone oils and onium-modified polyolefins, fluorocarbon-modified polyolefins, fluorocarbon-modified silicone oils, polyacrylic acids, and glycerol esters. Generally they are surfactant compounds. Commercial products that may be used as such leveling agents include one or more selected from among KP-323, 326, 341, 104, 110 and 112 (all products of Shin-Etsu Chemical Co., Ltd.); BYK®-300, 302, 306, 307, 310, 313, 315, 320, 322, 323, 325, 330, 331, 333, 342, 345, 346, 347, 348, 349, 370, 377, 378, 3455 and UV3500 (all products of BYK Chemie GmbH); Polyflow KL-100, 700 and LE-604 (all products of Kyoeisha Chemical Co., Ltd.); and Megafac F-251, 253, 410, 444, 477, and 551 to 572 (all products of DIC Corporation).

The amount of leveling agent included in the coating may be as mentioned above, although it is possible as well for no leveling agents to be added to the coating when working this invention.

The amount of involatile materials, which will eventually form cured layer, included in the radiation-curable coating composition is preferably 5 to 70 wt %, more preferably 10 to 60 wt%, and even more preferably 20 to 50 wt%. At less than 5 wt %, the layer tends to become a thin film. For some uses, the laminate ultimately obtained may then have inadequate weather resistance. On the other hand, at more than 70 wt%, handleability as a coating may be difficult.

Step (B): Irradiating the Uncured Film-Covered Article to Cure the Film

In step (B), radiation is applied to the uncured film obtained in step (A), thereby curing the film. The radiation is preferably of one or more type selected from among ultraviolet rays, infrared rays, electron beams, ionizing radiation and microwaves. In case of curing the uncured film by irradiating ultraviolet ray, the exposure dose is preferably in a range of 300 to 3,000 mJ/cm$^2$, more preferably 500 to 2,000 mJ/cm$^2$, and the exposure time is generally 600 to 1,800 seconds. The uncured film-covered article formed in step (A) may be preheated prior to such irradiation.

Radiation-Curable Coating

The radiation-curable coating of the invention is characterized by including a siloxane acrylate of above general formula (I).

In the radiation-curable coating of the invention, the proportion of siloxane acrylate of general formula (I), based on (relative to) the coating solids excluding the siloxane acrylate, is preferably 5 to 100 wt%, more preferably 10 to 80 wt%, and even more preferably 15 to 60 wt%. At less than 5 wt%, the leveling ability worsens. On the other hand, at

more than 100 wt %, the ability to laminate inorganic vapor-deposited layer (ii) thereon worsens.

The radiation-curable coating of the invention may further include, for example, ($\alpha$) (meth)acrylate including polyfunctional (meth)acrylate, ($\beta$) an acrylic polymer, ($\gamma$) inorganic oxide fine particles and ($\delta$) a light stabilizer.

($\alpha$) Polyfunctional (Meth)acrylate

The (meth)acrylates including polyfunctional (meth)acrylates that may be used in the radiation-curable coating of the invention are not particularly limited. For example, use can be made of monoesters such as methyl methacrylate (MMA), methyl acrylate (MA), ethyl methacrylate, ethyl acrylate, hydroxyethyl acrylate (HEA), hydroxyethyl methacrylate (HEMA), hydroxypropyl acrylate, 4-hydroxybutyl acrylate, isobutyl acrylate, tert-butyl acrylate, n-octyl acrylate, isooctyl acrylate, isononyl acrylate, lauryl acrylate, stearyl acrylate, isostearyl acrylate, isonorbornyl acrylate, tetrahydrofurfuryl acrylate, methoxyethyl acrylate, methoxypolyethylene glycol acrylate, (2-methyl-2-ethyl-1,3-dioxolan-4-yl)methyl acrylate, (cyclohexane spiro-2-(1,3-dioxolan-4-yl))methyl acrylate and (3-ethyloxetan-3-yl)methyl acrylate; diesters such as ethylene glycol diacrylate, propylene glycol diacrylate, butanediol diacrylate, pentanediol diacrylate, hexanediol diacrylate, heptanediol diacrylate, octanediol diacrylate, nonanediol diacrylate, decanediol diacrylate, glycerol 1,2-diacrylate, glycerol 1,3-diacrylate, pentaerythritol diacrylate, 2-hydroxy-3-acryloyloxypropyl methacrylate, tricyclodecane dimethanol diacrylate, dipropylene glycol diacrylate and tripropylene glycol diacrylate; polyfunctional esters such as glycerol triacrylate, trimethylolpropane triacrylate, pentaerythritol triacrylate, dipentaerythritol triacrylate, ethoxylated isocyanuric acid triacrylate, ethoxylated glycerol triacrylate, ethoxylated trimethylolpropane triacrylate, pentaerythritol tetraacrylate, dipentaerythritol hexaacrylate, ditrimethylolpropane tetraacrylate, ethoxylated pentaerythritol tetraacrylate, trimethylolpropane trimethacrylate and trispentaerythritol octaacrylate; and polyfunctional esters such as basic hydrolytic condensates of the following (meth)acryloyloxyalkylene alkoxysilanes: acryloyloxymethyl trimethoxysilane, acryloyloxymethyl dimethoxymethylsilane, acryloyloxymethyl methoxydimethylsilane, methacryloyloxymethyl trimethoxysilane, methacryloyloxymethyl dimethoxymethylsilane, methacryloyloxymethyl methoxydimethylsilane, 2-acryloyloxyethyl trimethoxysilane, 2-acryloyloxyethyl dimethoxymethylsilane, 2-acryloyloxyethyl methoxydimethylsilane, 2-methacryloyloxyethyl trimethoxysilane, 2-methacryloyloxyethyl dimethoxymethylsilane, 2-methacryloyloxyethyl methoxydimethylsilane, 3-acryloyloxypropyl trimethoxysilane, 3-acryloyloxypropyl dimethoxymethylsilane, 3-acryloyloxypropyl methoxydimethylsilane, 3-methacryloyloxypropyl trimethoxysilane, 3-methacryloyloxypropyl dimethoxymethylsilane, 3-methacryloyloxypropyl methoxydimethylsilane, 8-acryloyloxyoctyl trimethoxysilane, 8-methacryloyloxyoctyl trimethoxysilane, acryloyloxymethyl triethoxysilane, acryloyloxymethyl diethoxymethylsilane, acryloyloxymethyl ethoxydimethylsilane, methacryloyloxymethyl triethoxysilane, methacryloyloxymethyl diethoxymethylsilane, methacryloyloxymethyl ethoxydimethylsilane, 2-acryloyloxyethyl triethoxysilane, 2-acryloyloxyethyl diethoxymethylsilane, 2-acryloyloxyethyl ethoxydimethylsilane, 2-methacryloyloxyethyl triethoxysilane, 2-methacryloyloxyethyl diethoxymethylsilane, 2-methacryloyloxyethyl ethoxydimethylsilane, 3-acryloyloxypropyl triethoxysilane, 3-acryloyloxypropyl diethoxymethylsilane, 3-acryloyloxypropyl ethoxydimethylsilane, 3-methacryloyloxypropyl triethoxysilane, 3-methacryloyloxypropyl diethoxymethylsilane, 3-methacryloyloxypropyl ethoxydimethylsilane, 8-acryloyloxyoctyl triethoxysilane and 8-methacryloyloxyoctyl triethoxysilane.

Monoesters may be used in an amount, based on the total amount of component ($\alpha$), of preferably at least 0 wt% and not more than 49 wt %, more preferably at least 0 wt% and not more than 48 wt%, and even more preferably at least 0 wt% and not more than 45 wt%. Diesters may be used in an amount, based on the total amount of esters, of preferably at least 1 wt% and not more than 30 wt%, more preferably at least 2 wt% and not more than 25 wt%, and even more preferably at least 5 wt% and not more than 20 wt%. Polyfunctional esters may be used in an amount, based on the total amount of esters, of preferably at least 50 wt% and not more than 99 wt %, more preferably at least 50 wt% and not more than 90 wt %, and even more preferably at least 50 wt% and not more than 80 wt%. Although monoesters are an optional ingredient, they are important or desirable from the standpoint of making the coating solvent-free (or low-solvent), and may be used in place of solvent. When monoesters are included, the amount is desirably set to 3 wt% or more. When the proportion of monoesters is greater than 70 wt %, the film may become brittle. At a proportion of diesters below 1 wt%, the flexibility of the film may be inadequate, whereas at more than 30 wt%, the film may not have sufficient scuff resistance. The polyfunctional esters are an essential ingredient, but when included in an amount of less than 50 wt %, the film may not have a sufficient hardness.

($\beta$) Acrylic Polymer

Acrylic polymers that may be used in the radiation-curable coating of the invention are not particularly limited. For example, vinyl polymers of general formula (II) below may be used.

$$\text{Poly-}\ [(D)_d\text{-Co-}\ (E)_e\text{-co-}(F)_f] \qquad (II)$$

Here, D, E and F are each independently vinyl monomer units, the square brackets and "-co-" represent a random

copolymer, and "d", "e" and "f" stand for molar fractions. D is an alkoxysilyl group-containing vinyl monomer, and "d" is a molar fraction such that the content of monomer D with respect to the overall polymer is from 1 to 50 wt%. E is ultraviolet-absorbing vinyl monomer, and "e" is a molar fraction such that the content of monomer E with respect to the overall polymer is from 5 to 40 wt%. F is other monomer that is copolymerizable with these vinyl monomers, and "f" is a molar fraction such that the content of monomer F with respect to the overall polymer is [100 - (monomer D content) - (monomer E content)] wt%.

The vinyl monomer unit D is preferably formed by the addition polymerization of an alkoxysilyl group-containing vinyl monomer. The alkoxysilyl group-containing vinyl monomer may be one or more selected from the group consisting of (meth)acryloyloxyalkylene alkoxysilanes such as acryloyloxymethyl trimethoxysilane, acryloyloxymethyl dimethoxymethylsilane, acryloyloxymethyl methoxydimethylsilane, methacryloyloxymethyl trimethoxysilane, methacryloyloxymethyl dimethoxymethylsilane, methacryloyloxymethyl methoxydimethylsilane, 2-acryloyloxyethyl trimethoxysilane, 2-acryloyloxyethyl dimethoxymethylsilane, 2-acryloyloxyethyl methoxydimethylsilane, 2-methacryloyloxyethyl trimethoxysilane, 2-methacryloyloxyethyl dimethoxymethylsilane, 2-methacryloyloxyethyl methoxydimethylsilane, 3-acryloyloxypropyl trimethoxysilane, 3-acryloyloxypropyl dimethoxymethylsilane, 3-acryloyloxypropyl methoxydimethylsilane, 3-methacryloyloxypropyl trimethoxysilane, 3-methacryloyloxypropyl dimethoxymethylsilane, 3-methacryloyloxypropyl methoxydimethylsilane, 8-acryloyloxyoctyl trimethoxysilane, 8-methacryloyloxyoctyl trimethoxysilane, acryloxyloxymethyl triethoxysilane, acryloyloxymethyl diethoxymethylsilane, acryloyloxymethyl ethoxydimethylsilane, methacryloyloxymethyl triethoxysilane, methacryloyloxymethyl diethoxymethylsilane, methacryloyloxymethyl ethoxydimethylsilane, 2-acryloxyoxyethyl triethoxysilane, 2-acryloyloxyethyl diethoxymethylsilane, 2-acryloxyoxyethyl ethoxydimethylsilane, 2-methacryloyloxyethyl triethoxysilane, 2-methacryloyloxyethyl diethoxymethylsilane, 2-methacryloyloxyethyl ethoxydimethylsilane, 3-acryloyloxypropyl triethoxysilane, 3-acryloyloxypropyl diethoxymethylsilane, 3-acryloyloxypropyl ethoxydimethylsilane, 3-methacryloyloxypropyl triethoxysilane, 3-methacryloyloxypropyl diethoxymethylsilane, 3-methacryloyloxypropyl ethoxydimethylsilane, 8-acryloyloxyoctyl triethoxysilane and 8-methacryloyloxyoctyl triethoxysilane; linear and/or branched alkenyl alkoxysilanes such as vinyltrimethoxysilane, vinyldimethoxymethylsilane, vinylmethoxydimethylsilane, allyltrimethoxysilane, allyldimethoxymethylsilane, allylmethoxydimethylsilane, methallyltrimethoxysilane, methallyldimethoxymethylsilane, methallylmethoxydimethylsilane, 4-trimethoxysilyl-1-butene, 5-trimethoxysilyl-1-pentene, 6-trimethoxysilyl-1-hexene, 7-trimethoxysilyl-1-heptene and 8-trimethoxysilyl-1-octene; and aromatic unsaturated alkoxysilanes such as p-trimethoxysilylstyrene, 1,4-divinyl-2-trimethoxysilylbenzene and p-trimethoxysilyl-$\alpha$-methylstyrene. 3-Methacryloyloxypropyl trimethoxysilane (e.g., available under the product name "KBM-503" from Shin-Etsu Chemical Co., Ltd.) is preferred from the standpoint of availability and reactivity.

The vinyl monomer unit D may be copolymerized with the other monomer units E and F in a molar fraction d, based on the total amount of polymer (II), which is from 1 to 50 wt%, preferably 2 to 40 wt %, and more preferably 5 to 35 wt%. When the amount of vinyl monomer unit D is less than 1 wt% of the total amount of the polymer, forming a network with the inorganic fine particles may become difficult. On the other hand, when the amount of vinyl monomer unit D is more than 50 wt%, the storage stability and weather resistance may decline.

The vinyl monomer unit E is preferably formed by the addition polymerization of a vinyl monomer having an ultraviolet-absorbing group. Any vinyl monomer having both an ultraviolet-absorbing group and a vinylic polymerizable group may be used. In this invention, ultraviolet (UV) radiation refers to light having a wavelength of about 200 to about 400 nm. Exemplary UV-absorbing groups include organic groups having a benzotriazole, benzophenone, resorcinol or triazine group. Exemplary vinylic polymerizable groups include organic groups having a vinyl, allyl, styryl, acryl or methacryl group.

Such vinyl monomers having an organic UV-absorbing group are exemplified by (meth)acrylic monomers which have a UV-absorbing group on the molecule, such as the benzotriazole compounds of general formula (III) below and the benzophenone compounds of general formula (IV) below.

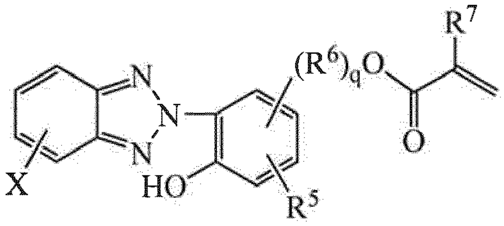

( III )

In formula (III), X is a hydrogen atom or a chlorine atom; $R^5$ is a hydrogen atom, a methyl group or a tertiary alkyl group of 4 to 8 carbon atoms; $R^6$ is a linear or branched alkylene group of 2 to 10 carbon atoms; $R^7$ is a hydrogen atom or a methyl group; and q is 0 or 1.

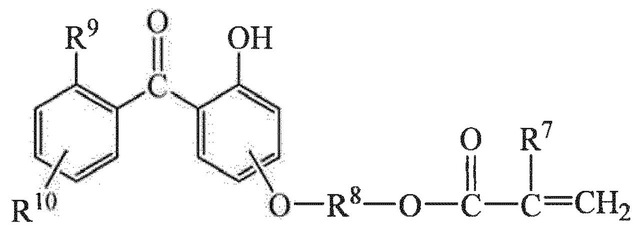

(IV)

In formula (IV), $R^7$ is as defined above; $R^8$ is a linear or branched alkylene group of 2 to 10 carbon atoms which may be substituted or unsubstituted; $R^9$ is a hydrogen atom or a hydroxyl group; and $R^{10}$ is a hydrogen atom, a hydroxyl group or an alkoxy group of 1 to 6 carbon atoms.

In general formula (III), examples of the tertiary alkyl of 4 to 8 carbon atoms represented by $R^5$ include tert-butyl, tert-pentyl, tert-hexyl, tert-heptyl, tert-octyl and di-tert-octyl groups. Examples of the linear or branched alkylene group of 2 to 10 carbon atoms represented by $R^6$ include ethylene, trimethylene, propylene, tetramethylene, 1,1-dimethyltetramethylene, butylene, octylene and decylene groups.

In general formula (IV), the linear or branched alkylene group of 2 to 10 carbon atoms represented by $R^8$ is exemplified by the same groups as mentioned above for $R^6$, and by groups obtained by replacing some portion of the hydrogen atoms thereon with halogen atoms. The alkoxy group represented by $R^{10}$ is exemplified by methoxy, ethoxy, propoxy and butoxy groups.

Examples of the benzotriazole compound of general formula (III) include 2-(2'-hydroxy-5'-(meth)acryloxyphenyl)-2H-benzotriazole, 2-(2'-hydroxy-3'-tert-butyl-5'-(meth)acryloxymethylphenyl)-2H-benzotriazole, 2-[2'-hydroxy-5'-(2-(meth)acryloxyethyl)phenyl]-2H-benzotriazole, 2-[2'-hydroxy-3'-tert-butyl-5'-(2-(meth)acryloxyethyl)-phenyl]-5-chloro-2H-benzotriazole and 2-[2'-hydroxy-3'-methyl-5'-(8-(meth)acryloxyoctyl)phenyl]-2H-benzotriazole.

Examples of the benzophenone compound of general formula (IV) include 2-hydroxy-4-(2-(meth)acryloxyethoxy)benzophenone, 2-hydroxy-4-(4-(meth)acryloxybutoxy)benzophenone, 2,2'-dihydroxy-4-(2-(meth)acryloxyethoxy)benzophenone, 2,4-dihydroxy-4'-(2-(meth)acryloxyethoxy)benzophenone, 2,2',4-trihydroxy-4'-(2-(meth)acryloxyethoxy)benzophenone, 2-hydroxy-4-(3-(meth)acryloxy-2-hydroxypropoxy)benzophenone and 2-hydroxy-4-(3-(meth)acryloxy-1-hydroxypropoxy)benzophenone.

The UV-absorbing vinyl monomer is preferably a benzotriazole compound of formula (III), with the use of 2-[2'-hydroxy-5'-(2-(meth)acryloxyethyl)phenyl]-2H-benzotriazole being especially preferred.

The UV-absorbing vinyl monomer may be of one type used alone or may be of two or more types used in admixture.

The vinyl monomer unit E may be copolymerized with the other monomer units D and F in a molar fraction e, based on the total amount of polymer (II), which is from 5 to 40 wt%, preferably 5 to 30 wt%, and more preferably 8 to 25 wt%. When the amount of vinyl monomer unit E is less than 5 wt% of the total amount of polymer, the weather resistance may be inadequate. On the other hand, when the amount of vinyl monomer unit E is more than 40 wt%, adhesion to the substrate may decrease.

Next, the other vinyl monomer unit F that is copolymerizable with vinyl monomer units D and E is not particularly limited so long as it is a copolymerizable monomer. Vinyl monomer unit F is exemplified by (meth)acrylic monomers having a cyclic hindered amine structure, (meth)acrylic esters, (meth)acrylonitrile, (meth)acrylamide, alkyl vinyl ethers, alkyl vinyl esters, styrene, and derivatives thereof.

Examples of (meth)acrylic monomers having a cyclic hindered amine structure include 2,2,6,6-tetramethyl-4-piperidinyl methacrylate and 1,2,2,6,6-pentamethyl-4-piperidinyl methacrylate.

Examples of (meth)acrylic esters and derivatives thereof include (meth)acrylic acid esters of monohydric alcohols, such as methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, tert-butyl (meth)acrylate, n-pentyl (meth)acrylate, isopentyl (meth)acrylate, n-hexyl (meth)acrylate, isohexyl (meth)acrylate, n-heptyl (meth)acrylate, isoheptyl (meth)acrylate, 2-ethylhexyl (meth)acrylate, n-octyl (meth)acrylate, isooctyl (meth)acrylate, n-nonyl (meth)acrylate, isononyl (meth)acrylate, n-decyl (meth)acrylate, isodecyl (meth)acrylate, n-undecyl (meth)acrylate, n-dodecyl (meth)acrylate, lauryl (meth)acrylate, palmityl (meth)acrylate, stearyl (meth)acrylate, cyclohexyl (meth)acrylate, 4-methylcyclohexyl (meth)acrylate, 4-tert-butylcyclohexyl (meth)acrylate, isobornyl (meth)acrylate, dicyclopentanyl (meth)acrylate, dicyclopentenyloxyethyl (meth)acrylate and benzyl (meth)acrylate; (meth)acrylic acid esters of alkoxy(poly)alkylene glycols, such as 2-methoxyethyl (meth)acrylate, 2-methoxypropyl (meth)acrylate, 3-methoxypropyl (meth)acrylate, 2-methoxybutyl (meth)acrylate, 3-methoxybutyl (meth)acrylate, 4-methoxybutyl (meth)acrylate, methoxypolyethylene glycol (meth)acrylate (the number of ethylene glycol units being, for example, 2 to 20) and methoxypolypropylene glycol (meth)acrylate (the number of propylene glycol units being, for example, 2 to 20); mono(meth)acrylic acid esters of polyhydric alcohols, such as 2-hydroxyethyl (meth)acrylate, 2-hydroxypropyl (meth)acrylate, 3-hydroxypropyl (meth)acrylate, 2-hydroxybutyl

(meth)acrylate, 3-hydroxybutyl (meth)acrylate, 4-hydroxybutyl (meth)acrylate, glycerol mono(meth)acrylate, pentaerythritol mono(meth)acrylate, polyethylene glycol mono(meth)acrylate (the number of ethylene glycol units being, for example, 2 to 20) and polypropylene glycol mono(meth)acrylate (the number of propylene glycol units being, for example, 2 to 20); poly(meth)acrylic acid esters of polyhydric alcohols, such as ethylene glycol di(meth)acrylate, propylene glycol di(meth)acrylate, butylene glycol di(meth)acrylate, glycerol di(meth)acrylate, glycerol tri(meth)acrylate, pentaerythritol di(meth)acrylate, pentaerythritol tetra(meth)acrylate, 1,4-cyclohexanediol di(meth)acrylate, polyethylene glycol di(meth)acrylate (the number of ethylene glycol units being, for example, 2 to 20), and polypropylene glycol di(meth)acrylate (the number of propylene glycol units being, for example, 2 to 20); poly(esters) of a non-polymerizable polybasic acid and a hydroxyalkyl (meth)acrylate, such as mono[2-(meth)acryloyloxyethyl] succinate, di[2-(meth)acryloyloxyethyl] succinate, mono[2-(meth)acryloyloxyethyl] adipate, di[2-(meth)acryloyloxyethyl] adipate, mono[2-(meth)acryloyloxyethyl] phthalate and di[2-(meth)acryloyloxyethyl] phthalate; amino group-containing (meth)acrylic esters such as 2-aminoethyl (meth)acrylate, 2-(N-methylamino)ethyl (meth)acrylate, 2-(N,N-dimethylamino)ethyl (meth)acrylate, 2-(N-ethylamino)ethyl (meth)acrylate, 2-(N,N-diethylamino)ethyl (meth)acrylate, 3-(N,N-dimethylamino)propyl (meth)acrylate and 4-(N,N-dimethylamino)butyl (meth)acrylate; and epoxy group-containing (meth)acrylic esters such as glycidyl (meth)acrylate.

Examples of (meth)acrylonitrile derivatives include α-chloroacrylonitrile, α-chloromethylacrylonitrile, α-trifluoromethylacrylonitrile, α-methoxyacrylonitrile, α-ethoxyacrylonitrile and vinylidene cyanide.

Examples of (meth)acrylamide derivatives include N-methyl (meth)acrylamide, N,N-dimethyl (meth)acrylamide, N-ethyl (meth)acrylamide, N,N-diethyl (meth)acrylamide, N-methoxy (meth)acrylamide, N,N-dimethoxy (meth)acrylamide, N-ethoxy (meth)acrylamide, N,N-diethoxy (meth)acrylamide, diacetone (meth)acrylamide, N-methylol (meth)acrylamide, N-(2-hydroxyethyl) (meth)acrylamide, N,N-dimethylaminomethyl (meth)acrylamide, N-(2-dimethylamino)ethyl (meth)acrylamide, N,N'-methylenebis(meth)acrylamide and N,N'-ethylenebis(meth)acrylamide.

Examples of alkyl vinyl ethers include methyl vinyl ether, ethyl vinyl ether, butyl vinyl ether and hexyl vinyl ether.

Examples of alkyl vinyl esters include vinyl formate, vinyl acetate, vinyl acrylate, vinyl butyrate, vinyl caproate and vinyl stearate.

Examples of styrene and derivatives thereof include styrene, α-methylstyrene and vinyltoluene.

Of these monomers, (meth)acrylic esters are preferred, with methyl (meth)acrylate, ethyl (meth)acrylate, isopropyl (meth)acrylate, n-butyl (meth)acrylate, isobutyl (meth)acrylate, n-hexyl (meth)acrylate, 2-ethylhexyl (meth)acrylate, isononyl (meth)acrylate, lauryl (meth)acrylate, cyclohexyl (meth)acrylate, 4-methylcyclohexyl (meth)acrylate, 4-tert-butylcyclohexyl (meth)acrylate, isobornyl (meth)acrylate, dicyclopentanyl (meth)acrylate and dicyclopentenyloxyethyl (meth)acrylate being especially preferred.

The vinyl monomer unit F may be a single monomer used alone or may be two or more monomers used in admixture.

The vinyl monomer unit F may be copolymerized with the other monomer units D and E in a molar fraction f, based on the total amount of polymer (II), which is [100 - (monomer D content) - (monomer E content)] wt %, or from 10 to 94 mol%, preferably 20 to 94 wt %, and more preferably 35 to 90 wt%. When the amount of vinyl monomer unit F, based on the total amount of polymer, is less than 10 wt%, defects in the coated appearance sometimes arise. On the other hand, when the amount of vinyl monomer unit F is more than 94 wt %, crosslinking with the inorganic fine particles is inadequate, which may result in a lower durability.

Component (β) is preferably obtained or obtainable by subjecting vinyl monomer units D, E and F to a copolymerization reaction. Copolymerization can easily be carried out by adding a peroxide such as dicumyl peroxide or benzoyl peroxide and a radical polymerization initiator selected from among azo compounds, such as azobisisobutyronitrile, to a solution containing monomers D, E and F, and carrying out the reaction under heating (50 to 150°C, especially 70 to 120°C, for 1 to 10 hours, especially 3 to 8 hours).

Component (β) has a polystyrene-equivalent weight-average molecular weight, as determined by gel permeation chromatography (GPC), of preferably between 1,000 and 300,000, and especially between 5,000 and 250,000. At too high a molecular weight, the viscosity becomes too high, which may make synthesis difficult to carry out and the polymer difficult to handle. On the other hand, a molecular weight that is too low may give rise to appearance defects such as whitening of the coating film and weather cracking, and sufficient adhesion, durability and weather resistance may not be obtained.

The component (β) used may be one prepared from the above ingredients, or a similar commercial product may be used. Examples of such commercial products include Newcoat UVA-101, 102, 103 and 104, and Vanaresin UVA-5080, 55T, 55MHB, 7075 and 73T (all available under these product names from Shin-Nakamura Chemical Co., Ltd.).

The acrylic polymer serving as component (β) may be a polycarbonate and/or polyester-based urethane-modified vinyl polymer. Polycarbonate and/or polyester-based urethane-modified vinyl polymer are used as adhesion promoters. The polycarbonate and/or polyester-based urethane-modified vinyl polymer undergoes layer separation with other ingredients within the cured film, forming a concentration gradient in the thickness direction of the film. Hence, the

affinity to the organic resin substrate increases and adhesion is manifested without a decline in the scuff resistance. The polycarbonate and/or polyester-based urethane-modified vinyl polymers is obtained by grafting a polycarbonate or polyester-based polyurethane onto a vinyl polymer. A vinyl polymer having on side chains a polycarbonate or polyester-based polyurethane obtained from the reaction of an aliphatic polycarbonate diol or an aliphatic polyester diol with an aromatic diisocyanate is preferred. A vinyl polymer having on side chains a polycarbonate-based urethane obtained from the reaction of an aliphatic polycarbonate diol with an aromatic diisocyanate is more preferred.

Specific examples of aliphatic polycarbonate diols include those based on 1,4-tetramethylene, 1,5-pentamethylene, 1,6-hexamethylene, 1,12-dodecane, 1,4-cyclohexane or a mixture thereof. Examples of aromatic diisocyanates include 4,4'-diphenylmethane diisocyanate, 2,4-tolylene diisocyanate, 2,6-tolylene diisocyanate, m-xylene diisocyanate, naphthalene diisocyanate, and mixtures thereof. By reacting these in the usual manner, a polycarbonate-based polyurethane can be obtained.

The monomer making up the vinyl polymer may be any monomer that contains a vinyl polymerizable group. Examples include methyl (meth)acrylate, ethyl (meth)acrylate, butyl (meth)acrylate, cyclohexyl (meth)acrylate, glycidyl (meth)acrylate, 2-hydroxyethyl (meth)acrylate, (meth)acrylic acid, styrene and vinyl acetate.

These monomers can be polymerized e.g. by known methods to obtain the vinyl polymer.

A urethane-modified vinyl polymer, when dissolved in an organic solvent, is preferable in terms of ease of synthesis and ease of handling. The organic solvent is preferably an organic solvent of relatively high polarity that readily dissolves the components of the polycarbonate and/or polyester-based urethane-modified vinyl polymer.
Examples of such organic solvents include alcohols such as isopropyl alcohol, n-butanol, isobutanol, tert-butanol and diacetone alcohol; ketones such as methyl ethyl ketone, diethyl ketone, methyl isobutyl ketone, cyclohexanone and diacetone alcohol; ethers such as dipropyl ether, dibutyl ether, anisole, dioxane, ethylene glycol monoethyl ether, ethylene glycol monobutyl ether, propylene glycol monomethyl ether and propylene glycol monomethyl ether acetate; and esters such as ethyl acetate, propyl acetate, butyl acetate and cyclohexyl acetate.

The polycarbonate and/or polyester-based urethane-modified vinyl polymer has a molecular weight, expressed as the weight-average molecular weight determined by GPC analysis against a polystyrene standard, of preferably 5,000 to 50,000, and more preferably 7,000 to 40,000. At a weight-average molecular weight of less than 5,000, sufficient adhesion to an organic resin substrate may not arise. On the other hand, at more than 50,000, the transparency when rendered into a cured film may be lost, the solubility in the composition may decrease, or separation may occur.

The polycarbonate and/or polyester-based urethane-modified vinyl polymer has a hydroxyl value, for the solid compound, which is preferably at least 10, and more preferably in the range of 20 to 100. At a hydroxyl value for the solid compound of less than 10, solubility in the composition may decrease and this component may separate out.

A commercial product may be used as the polycarbonate and/or polyester-based urethane-modified vinyl polymer component. For example, use can be made of Acrit 8UA-347, 357 and 366 (polycarbonate-based) and Acrit UA-140, 146, 301 and 318 (polyester-based) from Taisei Fine Chemical Co., Ltd.

($\gamma$) Inorganic Oxide Fine Particles

Inorganic oxide fine particles that may be used in the radiation-curable coating of the invention are not particularly limited, although preferred use can be made of one or more of the following types of inorganic oxide fine particles: silicon oxide, zinc oxide, titanium oxide, cerium oxide and aluminum oxide.

($\delta$) Light Stabilizer

Light stabilizers that may be used in the radiation-curable coating of the invention are not particularly limited, although preferred use can be made of (meth)acrylic monomers having a cyclic hindered amine structure, (meth)acrylic esters, (meth)acrylonitrile, (meth)acrylamide, alkyl vinyl ethers, alkyl vinyl esters, styrene, and derivatives thereof.

Specific examples of (meth)acrylic monomers having a cyclic hindered amine structure include 2,2,6,6-tetramethyl-4-piperidinyl methacrylate and 1,2,2,6,6-pentamethyl-4-piperidinyl methacrylate.

($\xi$) Other Ingredients

Other ingredients that may be used in the radiation-curable coating of the invention include ingredients such as curing catalysts, photoinitiators, solvents and UV absorbers that are familiar to those skilled in the art.

Ingredient Proportions in Radiation-Curable Coating

The radiation-curable composition of the invention is obtained by mixing component (I) together with such of components ($\alpha$) to ($\delta$) and component ($\xi$) as are selected. The suitable proportions of components ($\alpha$) to ($\delta$) in the base

coating exclusive of component (I) are given below per 100 parts by weight of the base coating solids. The amount of component (α) per 100 parts by weight is preferably 20 to 100 parts by weight, more preferably 30 to 89.9 parts by weight, and most preferably 30 to 79 parts by weight. At less than 20 parts by weight, the film strength may sometimes be inadequate. When the amount of component (α) is 100 parts by weight per 100 parts by weight of the base coating solids, the coating does not contain components (β) , (γ) and (δ) . Preferably, components (β) , (γ) and (δ) are contained in such amounts described below. The amount of component (β) per 100 parts by weight is preferably 5 to 30 parts by weight, and more preferably 10 to 20 parts by weight. At less than 5 parts by weight, the film flexibility may be less good or inadequate. At more than 30 parts by weight, the scuff resistance of the film may be less good or inadequate. The amount of component (γ) per 100 parts by weight is preferably 5 to 30 parts by weight, and more preferably 10 to 20 parts by weight. At less than 5 parts by weight, formation of an inorganic vapor-deposited layer thereon may be difficult. On the other hand, at more than 30 parts by weight, the film flexibility may be less good or inadequate. The amount of component (δ) per 100 parts by weight is preferably 0.1 to 10 parts by weight, and more preferably 1 to 5 parts by weight. At less than 0.1 part by weight, the film may have a tendency to yellow. On the other hand, at more than 10 parts by weight, the chemical stability of the film may be less good or inadequate. In cases where a leveling agent is included, it is desirably added in an amount indicated above.

The solvent may preferably be contained in an amount of 30 to 90 parts, especially 40 to 70 parts by weight per 100 parts by weight of the total amounts of component (I) and components (α) to (δ). Examples of the solvents include alcohols such as ethyl alcohol, cyclopentanol, isopropyl alcohol, n-butanol, isobutanol, tert-butanol and diacetone alcohol.

The photoinitiator may preferably be contained in an amount of 0.1 to 20 parts, especially 1 to 10 parts by weight per 100 parts by weight of the total amounts of component (I) and components (α) to (δ).

The UV absorber may preferably be contained in an amount of 1 to 10 parts, especially 3 to 8 parts by weight per 100 parts by weight of the total amounts of component (I) and components (α) to (δ).

## Coated Article

The radiation-curable coating of the invention can be used to form a coated article having a cured film layer (i) obtained by applying and curing the radiation-curable coating of the invention on at least one side of an organic resin substrate. In this coated article, the cured film not only has weather resistance and abrasion resistance, it also has a good adhesion with the organic resin substrate and enables an inorganic vapor-deposit layer to be laminated thereon. Examples of organic resin substrates that can be used in the invention include substrates made of single resins selected from the group consisting of polycarbonate resins, polyethylene terephthalate resins, polyethylene resins, polypropylene resins, polyoxymethylene resins, polyacrylic resins, polyepoxy resins, polyphenolic resins, polyetheretherketone resins and silicone resins, and substrates made of composites of one or more thereof (including multilayer composites and/or polymer alloys). A polycarbonate resin is especially preferred. The organic resin substrate has a thickness of preferably 0.1 to 100 mm, more preferably 1 to 10 mm, and still more preferably 4 to 8 mm. For special uses such as bulletproof applications, a substrate having a thickness of about 100 mm may be preferred. In automotive and other applications where lightweight properties are desired, a substrate having a thickness of about 1 to 10 mm is sometimes preferred. At a thickness of less than 0.1 mm, weathering deterioration of the resin substrate itself is pronounced, warpage during curing becomes conspicuous, or the organic resin substrate may deteriorate during lamination of an inorganic vapor-deposited layer on the cured film. In this invention, there is no particular upper limit in the thickness of the organic resin substrate, although in practical terms this is generally about 100 mm.

The film that is formed by applying and curing the radiation-curable coating of the invention on an organic resin substrate has a thickness of preferably 0.1 to 50 μm, more preferably 1 to 30 μm, and even more preferably 5 to 20 μm. At less than 0.1 μm, the weather resistance may sometimes be inadequate, whereas at more than 50 μm, cracking and other effects that worsen the physical properties of the film may sometimes arise.

## Laminate

The laminate obtained by laminating an inorganic vapor-deposited layer (ii) on the layer (i) obtained by applying and curing the radiation-curable coating of the invention on an organic resin exhibits a very high abrasion resistance and excellent weather resistance. The inorganic vapor-deposited layer (ii) is not particularly limited, provided it is formed by a dry film-forming process. Illustrative examples include layers composed primarily of any of various metals or metal oxides, nitrides or sulfides containing at least one element such as silicon, titanium, zinc, aluminum, gallium, indium, cesium, bismuth, antimony, boron, zirconium, tin and tantalum. Alternatively, a diamond-like carbon film layer having a high hardness and excellent dielectric properties may be used. The method of forming the inorganic vapor-deposited layer on layer (i) is not particularly limited, provided it is a dry film-forming process. Illustrative examples of suitable dry film-forming processes include physical vapor phase growth processes such as resistance heating evaporation, electron

beam evaporation, molecular beam epitaxial growth, ion beam deposition, ion plating and sputtering; and chemical vapor phase growth processes such as thermal CVD, plasma CVD, photo-assisted CVD, epitaxial CVD, atomic layer CVD and catalytic CVD. The thickness of the inorganic vapor-deposited layer is preferably from 0.1 to 10 μm.

## EXAMPLES

Synthesis Examples, Working Examples of the invention and Comparative Examples are given below by way of illustration.

### Synthesis Example 1

Synthesis of Siloxane Acrylate (I)

A two liter flask equipped with a stirrer, a condenser with a Dean-Stark trap, a dropping funnel and a thermometer was charged with 235 g (0.5 mol) of Methyl Silicate 51 (Colcoat Co., Ltd.), 0.1 g of TBT700 (Nippon Soda Co., Ltd.) and 0.6 g of di-tert-butylhydroxytoluene, and heated to 85°C. To this was added 551 g (5 mol) of hydroxyethyl acrylate, effecting a reaction. Methanol (80 g) was observed to distill off. The reaction mixture was treated for 2 hours under heating and reduced pressure (100°C, 5 mmHg), giving 606 g (yield, 95%) of a colorless liquid siloxane acrylate (I). The viscosity was 73 mPa·s, the specific gravity was 1.223, the refractive index was 1.4630, and the number of acrylic functional groups included by design per molecule was 10 equivalents.

### Synthesis Example 2

Synthesis of Acrylic Polymer

An acrylic polymer was synthesized as one coating ingredient (β). A two liter flask equipped with a stirrer, a condenser, a dropping funnel and a thermometer was charged with 33.7 g of diacetone alcohol and heated to 80°C under a stream of nitrogen. To this were successively added portions of both:

(1) a monomer mixed solution prepared beforehand by mixing together 20 g of γ-methacryloxypropyltrimethoxysilane (available as "KBM-503" from Shin-Etsu Chemical Co., Ltd.; this corresponds to monomer unit D; proportion of monomer unit D in polymer, 20 wt%), 15 g of 2-[2'-hydroxy-5'-(2-methacryloxyethyl)phenyl]-2H-benzotriazole (available as "RUVA-93" from Otsuka Chemical Co., Ltd.; this corresponds to monomer unit E; proportion of monomer unit E in polymer is 15 wt%), 60 g of methyl methacrylate (MMA) and 5 g of glycidyl methacrylate (GMA) (these correspond to monomer unit F; proportion of monomer unit F in polymer is 65 wt%), and 140 g of diacetone alcohol, and
(2) an initiator solution prepared beforehand by mixing together 0.5 g of 2,2'-azobis(2-methylbutyronitrile) and 40 g of diacetone alcohol.

Reaction was effected for 30 minutes at 80°C, following which the remaining portions of both solutions were added dropwise over 20 minutes at 80 to 90°C. The system was then stirred for 5 hours at 80 to 90°C, giving a diacetone alcohol solution of acrylic polymer (β) which contained 40 wt% of polymer component (β). This polymer solution had a viscosity of 5 Pa·s and the polymer component (β) had a weight-average molecular weight, as measured by GPC against a polystyrene standard, of $6\times10^4$.

### Comparative Synthesis Example 1

The acrylic-functional silsesquioxane described in paragraph [0378] of JP-A 2013-35274 was synthesized as a component for comparison with the siloxane acrylate (I) of this invention.

### Example 1

The following ingredients were each added to a brown plastic bottle (100 mL) and mixed together to give a uniform coating composition:

Siloxane acrylate (I) component from Synthesis Example 1 (9 g);

Coating ingredient (α):

trimethylolpropane triacrylate (TMPT-A, 6 g) and
hexanediol diacrylate (HDDA, 1 g);

Coating ingredient (β) :

the ingredient from Synthesis Example 2 (4 g (1.6 g in terms of polymer solids)) and the product Acrit 8UA-347 from Taisei Fine Chemical Co., Ltd. (1 g (0.3 g in terms of polymer solids));

Coating ingredients (γ) and (ξ) :

a dispersion of 1.5 g of the core-shell fine particles (described in JP 5704133) colloidally dispersed in 10 g of ethanol and 15 g of cyclopentanol, the particles having cores of titanium oxide in solid solution with tin (5 mol%) and manganese (1 mol%), with shells of silicon oxide (25 wt%) formed over the cores (75 wt%), the core fine particles having a volume average 50% cumulative distribution size of 15 nm, as measured by the dynamic light scattering method, and the core-shell fine particles having a similarly measured volume average 50% cumulative distribution size of 20 nm, and also colloidal silica (solids content, 0.5 g; "IPA-ST" from Nissan Chemical Industries, Ltd.);

Coating ingredient (δ):

2,2,6,6-tetramethyl-4-piperidyl methacrylate (ADK Stab LA-87, from Adeka Corporation; 0.3 g);

Photoinitiator:

2-hydroxy-2-methyl-1-phenyl-1-propanone (abbreviated here as "SB-PI703"; 1.3 g) and 2,4,6-trimethylbenzoyl diphenylphosphine oxide (abbreviated as "L-TPO"; 0.6 g); and

Ultraviolet absorber:

0.3 g of RUVA-93, and 0.3 g of 2-(2,4-dihydroxyphenyl)-4,6-bis(2,4-dimethylphenyl)-1,3,5-triazine reaction product (Tinuvin® 405, from BASF).

The resulting coating was flow coated onto one side of an organic resin substrate (5 mm thick) made of polycarbonate, and then leaned at about 70° to the vertical and left at rest for 5 minutes at room temperature. Following this period at rest, the resin substrate was placed horizontally in a 80°C oven and preheated for 5 minutes. After preheating, the substrate was placed in a UV irradiation system (ECS-401XN2, from Eye Graphics Co., Ltd.) equipped with a belt conveyor, and irradiated at an exposure dose of 600 mJ/$cm^2$ to cure the coating, thereby giving a coated article.

A laminate of the resulting coated article was then manufactured by a method described in the literature (Journal of the American Chemical Society, Vol. 128, p. 11018 (2006)). In a vacuum induced by a RF coil, a plasma was generated by supplying oxygen, argon and tetraethoxysilane (KBE-04, from Shin-Etsu Chemical Co., Ltd.) as the source gases and an inorganic vapor-deposited layer was formed. The experimental apparatus included a Pyrex® tube having an inside diameter of 25 mm that was held under a vacuum of $5\times10^{-7}$ torr, and a copper wire rod (JIS C 3002) wound to form a coil.

The resulting coated article was evaluated for abrasion resistance, adhesion, weather resistance, leveling ability and film thickness. The results are shown in Table 1.

Abrasion Resistance

The coated article was subjected to a Taber abrasion test in accordance with ASTM D1044, the haze after 500 cycles under a load of 500 g using CS-10F abrading wheels was measured (NDH5000SP, from Nippon Denshoku Industries Co., Ltd.), and the haze difference (ΔHz) between the values obtained before and after the test was determined. Coated articles having a haze difference (ΔHz) of 10 or less were rated as "Good"; those having a haze difference larger than 10 were rated as "NG".

Adhesion

A razor blade was used to make six scored lines in the film at 2 mm intervals in both the length and the width directions, thereby creating a crosscut pattern of 25 boxes. Cellotape® (Nichiban Co., Ltd.) was firmly affixed to the

pattern, after which the tape was rapidly peeled off at 90° inward, and the number of boxes (X) where the film did not peel off and remained behind was scored as X (out of a total of 25). Coated articles for which X was 25 were rated as "Good"; those for which X was less than 25 were rated as "NG".

Weather Resistance

Testing was carried out using the Eye Super UV Tester W-151 from Iwasaki Electric Co., Ltd. The coated article was irradiated with 300 $MJ/m^2$ of cumulative UV energy at a UV light intensity of $1\times10^3$ $W/m^2$ in a 60°C, 50% RH environment, and examined for changes in appearance. Specimens on which cracks, film delamination, whitening or yellowing appeared were rated as "NG"; specimens on which no abnormalities appeared were rated as "Good".

Leveling Ability

The appearance of the film obtained when the coating is applied and cured on the organic resin substrate was examined. Specimens on which was formed a smooth film with no observable abnormalities such as streaks, waviness and crawling were rated as "Good"; specimens on which leveling defects such as streaks, waviness and crawling occurred were rated as "NG".

Film Thickness

The surface area of the applied film formed on the organic resin substrate was measured by a high-speed Fourier transform thin-film interferometer (F-20, from Filmetrics Japan, Inc.).

The resulting laminates were evaluated for laminating ability, adhesion between cured film layer (i) and inorganic vapor-deposited layer (ii), and weather resistance. The results are shown in Table 1.

Laminating Ability

The laminate, when surface analyzed by infrared spectroscopy (ATR-IR), was rated as "Good" when the transparent film of silicon oxide adhered and formed well, and was rated as "NG" when the coated surface of the laminate was rough and had defects such as whitening and cracks.

Adhesion between Cured Film Layer (i) and Inorganic Vapor-Deposited Layer (ii)

A razor blade was used to make six scored lines in the film at 2 mm intervals in both the length and the width directions, thereby creating a crosscut pattern of 25 boxes. Cellotape@ (Nichiban Co., Ltd.) was firmly affixed to the pattern, after which the tape was rapidly peeled off at 90° inward, and the number of boxes (X) where separation between layer (i) and layer (ii) did not occur and these remained intact was scored as X (out of a total of 25). Laminates for which X was 25 were rated as "Good"; laminates for which X was less than 25 were rated as "NG".

Weather Resistance

The laminate was tested using the Eye Super UV Tester W-151 from Iwasaki Electric Co., Ltd. The laminate was irradiated with 300 $MJ/m^2$ of cumulative UV energy at a UV light intensity of $1\times10^3$ $W/m^2$ in a 60°C, 50% RH environment, and examined for changes in appearance. Laminates on which cracks, film delamination, whitening or yellowing appeared were rated as "NG"; laminates on which no abnormalities appeared were rated as "Good".

Examples 2 to 5

Aside from producing coating compositions in which a polyether-modified silicone (KP-341, from Shin-Etsu Chemical Co., Ltd.) was added as a leveling agent in a range of 1,000 to 3,000 ppm, based on the solids content of the coating composition in Example 1, the same operations were carried out as in Example 1. The actual ingredient contents and results for each of these Examples are shown in Table 1.

The results in Examples 1 to 5 demonstrate that the coating film has a good leveling ability regardless of the presence or absence of a leveling agent. Adhesion with the inorganic vapor-deposited layer was also good.

Table 1

| Type of ingredient | Specific ingredient (g) | Example | | | | |
|---|---|---|---|---|---|---|
| | | 1 | 2 | 3 | 4 | 5 |
| Component (I) | Synthesis Example 1 | 9 | 9 | 9 | 9 | 4 |
| Component (α) | Comparative Synthesis Example 1 | 0 | 0 | 0 | 0 | 5 |
| | DPHA | 0 | 0 | 0 | 0 | 0 |
| | A-GLY-9E (Shin-Nakamura Chemical) | 0 | 0 | 0 | 0 | 0 |
| | TMPT-A | 6 | 6 | 6 | 6 | 6 |
| | HDDA | 1 | 1 | 1 | 1 | 1 |
| Component (β) | Synthesis Example 2 | 4 | 4 | 4 | 4 | 4 |
| | Acrit 8UA-347 (Taisei Fine Chemical) | 1 | 1 | 1 | 1 | 1 |
| Component (γ) | IPA-ST (Nissan Chemical Industries) | 0.5 | 0.5 | 0.5 | 0.5 | 0.5 |
| | ingredient from JP 5704133 | 1.5 | 1.5 | 1.5 | 1.5 | 1.5 |
| Component (δ) | ADK Stab LA-87 (Adeka Corporation) | 0.3 | 0.3 | 0.3 | 0.3 | 0.3 |
| Component (ξ) | Ethanol | 10 | 10 | 10 | 10 | 10 |
| | Cyclopentanol | 15 | 15 | 15 | 15 | 15 |
| Photoinitiator | SB-PI703 | 1.3 | 1.3 | 1.3 | 1.3 | 1.3 |
| | L-TPO | 0.6 | 0.6 | 0.6 | 0.6 | 0.6 |
| UV absorber | RUVA-93 (Otsuka Chemical) | 0.3 | 0.3 | 0.3 | 0.3 | 0.3 |
| | Tinuvin® 405 (BASF) | 0.3 | 0.3 | 0.3 | 0.3 | 0.3 |
| Leveling agent | KP-341 (Shin-Etsu Chemical) | 0 ppm | 1,000 ppm | 2,000 ppm | 3,000 ppm | 3,000 ppm |
| Tests | | | | | | |
| Organic resin-coated article | Scuff resistance | good | good | good | good | good |
| | Adhesion | good | good | good | good | good |
| | Weather resistance | good | good | good | good | good |
| | Leveling ability | good | good | good | good | good |
| | Film thickness (μm) | 10 | 10 | 10 | 10 | 10 |
| Laminate having inorganic vapor-deposited layer | Laminating ability | good | good | good | good | good. |
| | Layer (i) / Layer (ii) adhesion | good | good | good | good | good |
| | Weather resistance | good | good | good | good | good |

Comparative Examples 1 to 5

The acrylic functional silsesquioxane produced in Comparative Synthesis Example 1 was used instead of siloxane acrylate (I). The concentration of leveling agent based on the resin solids of the coating was varied and evaluations were carried out in the same way as in Examples 1 to 5. The acrylic functional silsesquioxane produced in

Comparative Synthesis Example 1 had an acrylic functionality of 8 and the pure compound had a viscosity of 5.4 Pa·s. The actual ingredient contents and results for each of these Comparative Examples are shown in Table 2. When acrylic functional silsesquioxane was used, it became apparent that leveling ability and adhesion cannot both be achieved at the same time merely by increasing or decreasing the amount of leveling agent.

Table 2

| Type of ingredient | Specific ingredient (g) | Comparative Example | | | | |
|---|---|---|---|---|---|---|
| | | 1 | 2 | 3 | 4 | 5 |
| Component (I) | Synthesis Example 1 | 0 | 0 | 0 | 0 | 0 |
| Component (α) | Comparative Synthesis Example 1 | 9 | 9 | 9 | 9 | 9 |
| | DPHA | 0 | 0 | 0 | 0 | 0 |
| | A-GLY-9E (Shin-Nakamura Chemical) | 0 | 0 | 0 | 0 | 0 |
| | TMPT-A | 6 | 6 | 6 | 6 | 6 |
| | HDDA | 1 | 1 | 1 | 1 | 1 |
| Component (β) | Synthesis Example 2 | 4 | 4 | 4 | 4 | 4 |
| | Acrit 8UA-347 (Taisei Fine Chemical) | 1 | 1 | 1 | 1 | 1 |
| Component (γ) | IPA-ST (Nissan Chemical Industries) | 0.5 | 0.5 | 0.5 | 0.5 | 0.5 |
| | ingredient from JP 5704133 | 1.5 | 1.5 | 1.5 | 1.5 | 1.5 |
| Component (δ) | ADK Stab LA-87 (Adeka Corporation) | 0.3 | 0.3 | 0.3 | 0.3 | 0.3 |
| Component (ξ) | Ethanol | 10 | 10 | 10 | 10 | 10 |
| | Cyclopentanol | 15 | 15 | 15 | 15 | 15 |
| Photoinitiator | SB-PI703 | 1.3 | 1.3 | 1.3 | 1.3 | 1.3 |
| | L-TPO | 0.6 | 0.6 | 0.6 | 0.6 | 0.6 |
| UV absorber | RUVA-9.3 (Otsuka Chemical) | 0.3 | 0.3 | 0.3 | 0.3 | 0.3 |
| | Tinuvin® 405 (BASF) | 0.3 | 0.3 | 0.3 | 0.3 | 0.3 |
| Leveling agent | KP-341 (Shin-Etsu Chemical) | 0 ppm | 1,000 ppm | 2,000 ppm | 3,000 ppm | 4,000 ppm |
| Tests | | | | | | |
| Organic resin-coated article | Scuff resistance | good | good | good | good | good |
| | Adhesion | good | good | good | good | good |
| | Weather resistance | good | good | good | good | good |
| | Leveling ability | NG | NG | good | good | good |
| | Film thickness (μm) | 12 | 12 | 12 | 12 | 12 |
| Laminate having inorganic vapor-deposited layer | Laminating ability | good | good | good | good | good |
| | Layer (i) / Layer (ii) adhesion | good | good | NG | NG | NG |
| | Weather resistance | good | good | good | good | good |

Comparative Examples 6 to 10

Aside from using dipentaerythritol hexaacrylate (DPHA) instead of siloxane acrylate (I), the concentration of leveling agent based on the resin solids of the coating was varied and evaluations were carried out in the same way as in Examples 1 to 5. The acrylic functionality of DPHA was 6 and the pure compound had a viscosity of 6.3 Pa·s. The actual ingredient contents and results for each of these Comparative Examples are shown in Table 3. When DPHA was used as a main ingredient, the ability to laminate the inorganic vapor-deposited layer on the cured film was poor.

Table 3

| Type of ingredient | Specific ingredient (g) | Comparative Example | | | | |
|---|---|---|---|---|---|---|
| | | 6 | 7 | 8 | 9 | 10 |
| Component (I) | Synthesis Example 1 | 0 | 0 | 0 | 0 | 0 |
| Component (α) | Comparative Synthesis Example 1 | 0 | 0 | 0 | 0 | 0 |
| | DPHA | 9 | 9 | 9 | 9 | 9 |
| | A-GLY-9E (Shin-Nakamura Chemical) | 0 | 0 | 0 | 0 | 0 |
| | TMPT-A | 6 | 6 | 6 | 6 | 6 |
| | HDDA | 1 | 1 | 1 | 1 | 1 |
| Component (β) | Synthesis Example 2 | 4 | 4 | 4 | 4 | 4 |
| | Acrit 8UA-347 (Taisei Fine Chemical) | 1 | 1 | 1 | 1 | 1 |
| Component (γ) | IPA-ST (Nissan Chemical Industries) | 0.5 | 0.5 | 0.5 | 0.5 | 0.5 |
| | ingredient from JP 5704133 | 1.5 | 1.5 | 1.5 | 1.5 | 1.5 |
| Component (δ) | ADK Stab LA-87 (Adeka Corporation) | 0.3 | 0.3 | 0.3 | 0.3 | 0.3 |
| Component (ξ) | Ethanol | 10 | 10 | 10 | 10 | 10 |
| | Cyclopentanol | 15 | 15 | 15 | 15 | 15 |
| Photoinitiator | SB-PI703 | 1.3 | 1.3 | 1.3 | 1.3 | 1.3 |
| | L-TPO | 0.6 | 0.6 | 0.6 | 0.6 | 0.6 |
| UV absorber | RUVA-93 (Otsuka Chemical) | 0.3 | 0.3 | 0.3 | 0.3 | 0.3 |
| | Tinuvin® 405 (BASF) | 0.3 | 0.3 | 0.3 | 0.3 | 0.3 |
| Leveling agent | KP-341 (Shin-Etsu Chemical) | 0 ppm | 1,000 ppm | 2,000 ppm | 3,000 ppm | 4,000 ppm |
| Tests | | | | | | |
| Organic resin-coated article | Scuff resistance | good | good | good | good | good |
| | Adhesion | good | good | good | good | good |
| | Weather resistance | good | good | good | good | good |
| | Leveling ability | NG | NG | good | good | good |
| | Film thickness (μm) | 11 | 11 | 11 | 11 | 11 |

(continued)

| Type of ingredient | Specific ingredient (g) | Comparative Example | | | | |
|---|---|---|---|---|---|---|
| | | 6 | 7 | 8 | 9 | 10 |
| Laminate having inorganic vapor-deposited layer | Laminating ability | NG | NG | NG | NG | NG |
| | Layer (i) / Layer (ii) adhesion | NG | NG | NG | NG | NG |
| | Weather resistance | NG | NG | NG | NG | NG |

Comparative Examples 11 to 15

Aside from using a low-viscosity acrylate having polyether tethers (A-GLY-9E, from Shin-Nakamura Chemical Co., Ltd.) instead of siloxane acrylate (I), the concentration of leveling agent based on the resin solids of the coating was varied and evaluations were carried out in the same way as in Examples 1 to 5. The acrylic functionality of A-GLY-9E was 3 and the pure compound had a viscosity of 190 Pa·s. The actual ingredient contents and results for each of these Comparative Examples are shown in Table 4. A-GLY-9E has a low viscosity and low surface activity and thus exhibited a leveling ability, but the weather resistance was poor and the ability to laminate the inorganic vapor-deposited layer on the cured film was also poor.

Table 4

| Type of ingredient | Specific ingredient (g) | Comparative Example | | | | |
|---|---|---|---|---|---|---|
| | | 11 | 12 | 13 | 14 | 15 |
| Component (I) | Synthesis Example 1 | 0 | 0 | 0 | 0 | 0 |
| Component (α) | Comparative Synthesis Example 1 | 0 | 0 | 0 | 0 | 0 |
| | DPHA | 0 | 0 | 0 | 0 | 0 |
| | A-GLY-9E (Shin-Nakamura Chemical) | 9 | 9 | 9 | 9 | 9 |
| | TMPT-A | 6 | 6 | 6 | 6 | 6 |
| | HDDA | 1 | 1 | 1 | 1 | 1 |
| Component (β) | Synthesis Example 2 | 4 | 4 | 4 | 4 | 4 |
| | Acrit 8UA-347 (Taisei Fine Chemical) | 1 | 1 | 1 | 1 | 1 |
| Component (γ) | IPA-ST (Nissan Chemical Industries) | 0.5 | 0.5 | 0.5 | 0.5 | 0.5 |
| | ingredients from JP 5704133 | 1.5 | 1.5 | 1.5 | 1.5 | 1.5 |
| Component (δ) | ADK Stab LA-87 (Adeka Corporation) | 0.3 | 0.3 | 0.3 | 0.3 | 0.3 |
| Component (ξ) | Ethanol | 10 | 10 | 10 | 10 | 10 |
| | Cyclopentanol | 15 | 15 | 15 | 15 | 15 |
| Photoinitiator | SB-PI703 | 1.3 | 1.3 | 1.3 | 1.3 | 1.3 |
| | L-TPO | 0.6 | 0.6 | 0.6 | 0.6 | 0.6 |
| UV absorber | RUVA-93 (Otsuka Chemical) | 0.3 | 0.3 | 0.3 | 0.3 | 0.3 |
| | Tinuvin® 405 (BASF) | 0.3 | 0.3 | 0.3 | 0.3 | 0.3 |

(continued)

| Type of ingredient | Specific ingredient (g) | Comparative Example | | | | |
|---|---|---|---|---|---|---|
| | | 11 | 12 | 13 | 14 | 15 |
| Leveling agent | KP-341 (Shin-Etsu Chemical) | 0 ppm | 1,000 ppm | 2,000 ppm | 3,000 ppm | 4,000 ppm |
| Tests | | | | | | |
| Organic resin-coated article | Scuff resistance | good | good | good | good | good |
| | Adhesion | NG | NG | NG | NG | NG |
| | Weather resistance | NG | NG | NG | NG | NG |
| | Leveling ability | good | good | good | good | good |
| | Film thickness ($\mu$m) | 10 | 10 | 10 | 10 | 10 |
| Laminate having inorganic vapor-deposited layer | Laminating ability | NG | NG | NG | NG | NG |
| | Layer (i) / Layer (ii) adhesion | NG | NG | NG | NG | NG |
| | Weather resistance | NG | NG | NG | NG | NG |

Comparative Examples 16 to 20

Aside from diluting the coating compositions produced in Comparative Examples 1 to 5 by increasing the amount of cyclopentanol, the same operations were carried out. The actual ingredient contents and results for each of the Comparative Examples are shown in Table 5. When the coatings were diluted, although there did exist a region in which a leveling ability and adhesion of the inorganic vapor-deposited layer were both achieved by increasing or decreasing the amount of leveling agent, the film thickness became small and the resulting coated articles and laminates had poor weather resistances.

Table 5

| Type of ingredient | Specific ingredient (g) | Comparative Example | | | | |
|---|---|---|---|---|---|---|
| | | 16 | 17 | 18 | 19 | 20 |
| Component (I) | Synthesis Example 1 | 0 | 0 | 0 | 0 | 0 |
| Component ($\alpha$) | Comparative Synthesis Example 1 | 9 | 9 | 9 | 9 | 9 |
| | DPHA | 0 | 0 | 0 | 0 | 0 |
| | A-GLY-9E (Shin-Nakamura Chemical) | 0 | 0 | 0 | 0 | 0 |
| | TMPT-A | 6 | 6 | 6 | 6 | 6 |
| | HDDA | 1 | 1 | 1 | 1 | 1 |
| Component ($\beta$) | Synthesis Example 2 | 4 | 4 | 4 | 4 | 4 |
| | Acrit 8UA-347 (Taisei Fine Chemical) | 1 | 1 | 1 | 1 | 1 |
| Component ($\gamma$) | IPA-ST (Nissan Chemical Industries) | 0.5 | 0.5 | 0.5 | 0.5 | 0.5 |
| | ingredient from JP 5704133 | 1.5 | 1.5 | 1.5 | 1.5 | 1.5 |
| Component ($\delta$) | ADK Stab LA-87 (Adeka Corporation) | 0.3 | 0.3 | 0.3 | 0.3 | 0.3 |

(continued)

| Type of ingredient | Specific ingredient (g) | Comparative Example | | | | |
|---|---|---|---|---|---|---|
| | | 16 | 17 | 18 | 19 | 20 |
| Component (ξ) | Ethanol | 10 | 10 | 10 | 10 | 10 |
| | Cyclopentanol | 150 | 150 | 150 | 150 | 150 |
| Photo initiator | SB-PI703 | 1.3 | 1.3 | 1.3 | 1.3 | 1.3 |
| | L-TYPO | 0.6 | 0.6 | 0.6 | 0.6 | 0.6 |
| UV absorbed | RUVA-93 (Otsuka Chemical) | 0.3 | 0.3 | 0.3 | 0.3 | 0.3 |
| | Tinuvin® 405 (BASF) | 0.3 | 0.3 | 0.3 | 0.3 | 0.3 |
| Leveling agent | KP-341 (Shin-Etsu Chemical) | 0 ppm | 1,000 ppm | 2,000 ppm | 3,000 ppm | 4, 000 ppm |
| Tests | | | | | | |
| Organic resin-coated article | Scuff resistance | good | good | good | good | good |
| | Adhesion | good | good | good | good | good |
| | Weather resistance | NG | NG | NG | NG | NG |
| | Leveling ability | NG | good | good | good | good. |
| | Film thickness (μm) | 3 | 3 | 3 | 3 | 3 |
| Laminate having inorganic vapor-deposited layed | Laminating ability | good | good | good | good | good |
| | Layer (i) / Layer (ii) adhesion | good | good | NG | NG | NG |
| | Weather resistance | NG | NG | NG | NG | NG |

The siloxane acrylate-containing radiation-curable coating compositions disclosed herein are found to have excellent leveling ability and can be used in coating applications where a smooth coating surface is required. The coating composition, coating method, coated article and laminate of the invention can be used as, for example, automobile headlight covers, protective films for liquid crystal displays used outdoors, building materials such as car ports and sunroofs, articles for transportation equipment such as motorcycle windshields and windows for bullet trains and heavy construction equipment, automotive glazing, primers for chemical vapor deposition, and protective films for light collecting mirrors in solar cells.

NOTES

The entire disclosure of Japanese Patent Application No. 2015-098093, the priority of which is claimed herein, is incorporated herein by reference as a precaution.

Although some preferred embodiments have been described, many modifications and variations may be made thereto in light of the above teachings. It is therefore to be understood that the invention may be practised otherwise than as specifically described without departing from the scope of the general teachings herein.

For the avoidance of doubt it is confirmed that in the general description above, in the usual way the proposal of general preferences and options in respect of different features of the method, article, composition and laminate constitutes the proposal of general combinations of those general preferences and options for the different features, insofar as they are combinable and compatible and are put forward in the same context.

**Claims**

**1.** A method of manufacturing a coated article, comprising the steps of:

(A) applying a radiation-curable coating composition to an organic resin substrate so as to obtain an uncured film-covered article, and

(B) irradiating the uncured film-covered article with radiation to cure the film,

wherein the radiation-curable coating contains a siloxane acrylate of general formula (I) below

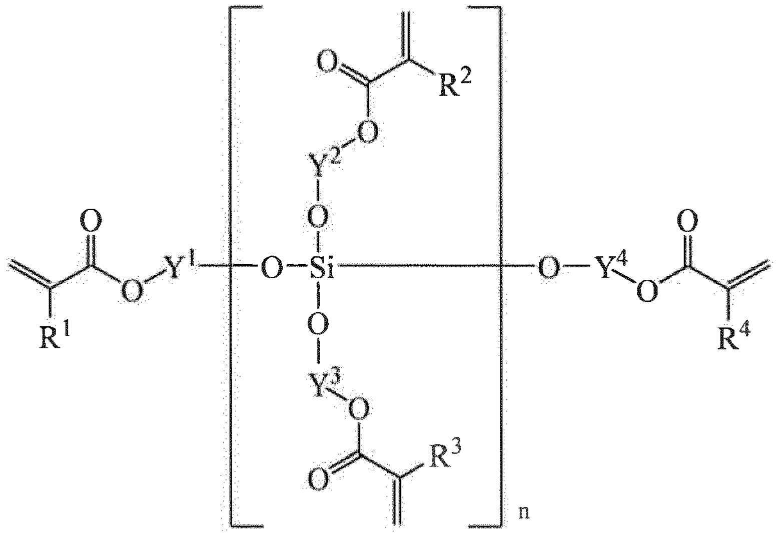

(I)

wherein $R^1$, $R^2$, $R^3$ and $R^4$ are each independently a hydrogen atom or a methyl group; $Y^1$, $Y^2$, $Y^3$ and $Y^4$ are each independently an alkylene group of 1 to 10 carbon atoms; and n is an integer of at least 1 and up to 10.

2. The manufacturing method of claim 1, wherein the radiation-curable coating further comprises (α) polyfunctional (meth)acrylate, and one or more selected from (β) acrylic polymers, (γ) inorganic oxide fine particles and (δ) light stabilizers.

3. The manufacturing method of claim 2, wherein the proportion of siloxane acrylate of general formula (I), based on the coating solids exclusive of siloxane acrylate, is 5 to 100 wt%, and the proportions of (meth)acrylate (α), acrylic polymer (β), inorganic oxide fine particles (γ) and light stabilizer (δ) in the base coating exclusive of component (I) are such that the amount of component (α) is 30 to 89.9 parts, the amount of component (β) is 5 to 30 parts, the amount of component (γ) is 5 to 30 parts and the amount of components (δ) is 0.1 to 10 parts by weight in 100 parts by weight of the base coating solids.

4. The manufacturing method of any one of claims 1 to 3, wherein the radiation-curable coating has a leveling agent content which is 0 to 3,000 ppm, based on the involatile solids of the coating.

5. A radiation-curable coating composition comprising a siloxane acrylate of general formula (I):

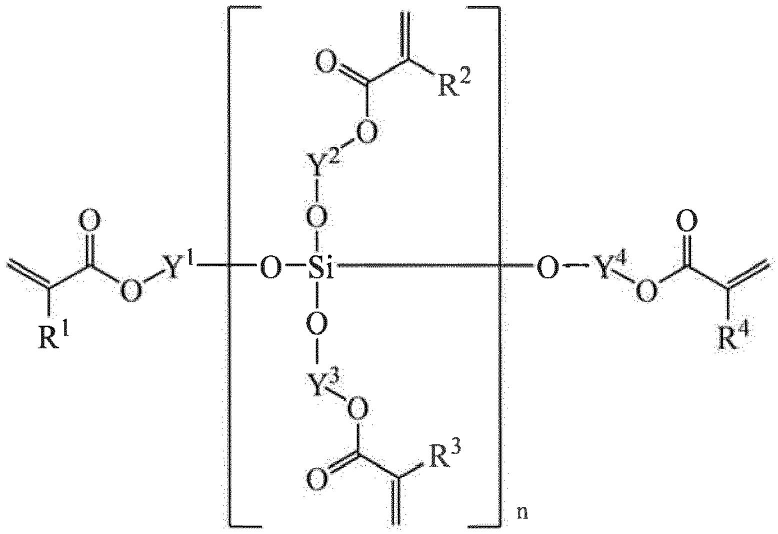

(I)

wherein $R^1$, $R^2$, $R^3$ and $R^4$ are each independently a hydrogen atom or a methyl group; $Y^1$, $Y^2$, $Y^3$ and $Y^4$ are each independently an alkylene group of 1 to 10 carbon atoms; and n is an integer of at least 1 and up to 10.

**6.** A radiation-curable coating composition of claim 5 which comprises polyfunctional (meth)acrylate.

**7.** A radiation-curable coating composition of claim 5 or 6 which comprises one or more selected from ($\beta$) acrylic polymers, ($\gamma$) inorganic oxide fine particles and ($\delta$) light stabilizers.

**8.** A radiation-curable coating composition of claim 6 and 7, wherein the proportions of polyfunctional (meth)acrylate ($\alpha$), acrylic polymer ($\beta$), inorganic oxide fine particles ($\gamma$) and light stabilizer ($\delta$) in the base coating exclusive of component (I) are such that the amount of component ($\alpha$) is 30 to 89.9 parts, the amount of component ($\beta$) is 5 to 30 parts, the amount of component ($\gamma$) is 5 to 30 parts and the amount of components ($\delta$) is 0.1 to 10 parts by weight in 100 parts by weight of the base coating solids.

**9.** A radiation-curable coating composition of any one of claims 5 to 8 wherein the proportion of siloxane acrylate of general formula (I), based on the coating solids excluding the siloxane acrylate, is 5 to 100 wt%.

**10.** A radiation-curable coating composition of any one of claims 5 to 9, wherein a leveling agent content is 0 to 3,000 ppm based on the involatile solids of the coating composition.

**11.** A radiation-curable coating composition of any one of claims 5 to 10 in which the amount of involatile coating solids is from 10 to 60 wt%.

**12.** A laminate which comprises, arranged as successive layers:

an organic resin substrate,

(i) a layer formed by applying and curing a radiation-curable coating composition of any one of claims 5 to 11 on at least one side of the substrate, and
(ii) an inorganic vapor-deposited layer,

wherein layer (i) has a thickness of at least 5 $\mu$m and not more than 20 $\mu$m, and layer (ii) is formed by a dry film-forming method.

Europäisches Patentamt
European Patent Office
Office européen des brevets

# EUROPEAN SEARCH REPORT

Application Number
EP 16 16 9318

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br><br><br><br><br><br><br><br><br>Y | DATABASE CA [Online]<br>CHEMICAL ABSTRACTS SERVICE, COLUMBUS, OHIO, US;<br>1993,<br>YAMAMOTO, NAOKI ET AL: "UV-curable coating compositions and coated articles",<br>XP002759951,<br>retrieved from STN<br>Database accession no. 1993:628163<br>* abstract *<br>& YAMAMOTO, NAOKI ET AL: "UV-curable coating compositions and coated articles",<br>JPN. KOKAI TOKKYO KOHO, 11 PP. CODEN: JKXXAF,<br>6 April 1994 (1994-04-06),<br>----- | 1-11<br><br><br><br><br><br><br><br><br><br>12 | INV.<br>C08J7/04<br>C09D4/06 |
| X | EP 2 398 862 A1 (ESSILOR INT [FR])<br>28 December 2011 (2011-12-28)<br>* examples 1A-1D; table 1 *<br>* claim 12 *<br>----- | 1,2,4-7,<br>9-11 | TECHNICAL FIELDS SEARCHED (IPC) |
| Y,D | JP 2013 035274 A (KANSAI PAINT CO LTD)<br>21 February 2013 (2013-02-21)<br>* paragraph [0413] *<br>----- | 12 | C09D<br>C08J |

The present search report has been drawn up for all claims

2

| Place of search | Date of completion of the search | Examiner |
|---|---|---|
| The Hague | 18 July 2016 | Fischer, Brigitte |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 16 16 9318

This annex lists the patent family members relating to the patent documents cited in the above-mentioned European search report. The members are as contained in the European Patent Office EDP file on
The European Patent Office is in no way liable for these particulars which are merely given for the purpose of information.

18-07-2016

| Patent document cited in search report | Publication date | Patent family member(s) | Publication date |
|---|---|---|---|
| EP 2398862 A1 | 28-12-2011 | BR PI1006962 A2 | 12-04-2016 |
| | | CA 2750463 A1 | 26-08-2010 |
| | | CN 102317380 A | 11-01-2012 |
| | | EP 2398862 A1 | 28-12-2011 |
| | | ES 2405986 T3 | 04-06-2013 |
| | | JP 5877713 B2 | 08-03-2016 |
| | | JP 2012518045 A | 09-08-2012 |
| | | PT 2398862 E | 13-05-2013 |
| | | US 2010210750 A1 | 19-08-2010 |
| | | WO 2010094558 A1 | 26-08-2010 |
| JP 2013035274 A | 21-02-2013 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 5234065 B
- JP 2011026594 A
- JP 5204634 B
- JP 2009179678 A
- JP 2013082941 A
- JP 2013035274 A
- JP 5704133 B
- JP 2015098093 A

### Non-patent literature cited in the description

- *Journal of the American Chemical Society,* 2006, vol. 128, 11018